# EUROPÄISCHE PATENTSCHRIFT

(11) **EP 1 414 586 B1**
(45) Veröffentlichungstag und Bekanntmachung des Hinweises auf die Patenterteilung: **22.09.2010**
(21) Anmeldenummer: 02722264.5
(22) Anmeldetag: 22.03.2002
(51) Int. Cl.: B05D 5/00

(54) **KOMPOSITSCHICHT UND VERFAHREN ZUR HERSTELLUNG EINER KOMPOSITSCHICHT**
COMPOSITE LAYER AND METHOD FOR PRODUCING SAID COMPOSITE LAYER
COUCHE DE COMPOSITE ET SON PROCEDE DE PRODUCTION

(30) Priorität: 23.03.2001 DE 10114306
(43) Veröffentlichungstag der Anmeldung: 06.05.2004
(73) Patentinhaber: Fraunhofer-Gesellschaft zur Förderung der angewandten Forschung e.V., 80686 München (DE)
(72) Erfinder: JUNG, Thomas, 38173 Hötzum (DE)
(74) Vertreter: Pfenning, Meinig & Partner GbR
(86) Internationale Anmeldenummer: PCT/EP2002/003261
(87) Internationale Veröffentlichungsnummer: WO 2002/076631

(56) Entgegenhaltungen:
- WO-A-97/00734

## Beschreibung

Die Erfindung betrifft eine Kompositschicht aus einer Partikel enthaltenden Matrix und ein Verfahren zur Herstellung dieser Kompositschichten auf Substraten. Die Kompositschichten weisen einen geringen Matrixanteil auf, wobei als Partikel vorzugsweise kristalline Hartstoffe (z.B. refraktäre Oxide, Nitride oder Karbide) eingesetzt werden. Bevorzugte Verwendung finden diese Kompositschichten für den Verschleiß- und Korrosionsschutz von Bauteilen.

Unter einer Kompositschicht wird eine Schicht verstanden, die aus mindestens zwei verschiedenen Materialien (Phasen) besteht. Als Kompositschicht im engeren Sinne wird eine Schicht verstanden, die aus Partikeln und einer Matrix besteht, wobei die Partikel vollständig in die Matrix eingebettet sind. Derartige mehrphasige Schichten weisen gegenüber einphasigen Schichten aus den gleichen Materialien oft deutlich bessere Gebrauchseigenschaften auf. Beispielsweise kann durch die Einbettung von Hartstoff-Partikeln in eine Matrix aus einem elastischen Material dessen Verschleißbeständigkeit deutlich erhöht werden, ohne die mit der Sprödigkeit des Hartstoffes als einphasige Schicht verbundenen Nachteile in Kauf nehmen zu müssen.

Bekannt sind verschiedene Verfahren zu Herstellung von Kompositschichten. In C. Jakob, F. Erler, R. Nutsch, S. Steinhäuser, B. Wielage, A. Zschunke, Metalloberfläche, Carl Hanser Verlag München, Jahrgang 2000, S. 9 wird die Herstellung von Kompositschichten mittels elektrochemischer Abscheidung beschrieben, indem einem nickelhaltigen Elektrolyten Metalloxidpulver beigfügt werden (Aluminiumoxid und Titanoxid). Die dabei entstehende Schicht besteht aus einer Nickel-Matrix, in der Metalloxidpartikel eingebettet sind.

Ein wesentlicher Nachteil dieses Verfahrens ist, dass der Partikelanteil nur etwa 11% des Schichtvolumens beträgt. Dadurch werden die mechanischen Eigenschaften derartiger Schichten, insbesondere die Härte und der Verschleiß, im wesentlichen durch das relativ weiche Metall bestimmt. Außerdem ist die Vielfalt der abscheidbaren Matrix-Materialien auf wenige Metalle begrenzt.

Es ist bekannt, dass aus bestimmten Materialien sehr harte Kompositschichten hergestellt werden können, wenn der Matrixanteil deutlich weniger als 50% des Schichtvolumens beträgt. In J. Musil, P. Zeman, H. Hrubý, P. H. Mayrhofer, Surface and Coatings Technology 120-121 (1999), S. 179 wird eine Schicht mit einem geringen Matrixanteil und ein Verfahren zu ihrer Herstellung beschrieben. Die Schicht besteht aus nanokristallinen Zirkonnitrid-Partikeln, die in eine Matrix aus Kupfer eingebettet sind. Die Schichten weisen eine extreme Härte auf. Das Verfahren beruht auf der Kathodenzerstäubung eines Legierungstargets aus Zirkonium und Kupfer in einer stickstoffhaltigen Atmosphäre. In Veprek, M. Haussmann, S Reiprich, Li Shizhi, J. Dian, Surface and Coatings Technology 86-87 (1996), S. 394 werden Titannitrid (Partikel) / Siliziumnitrid (Matrix)-Schichten hergestellt durch Chemische Dampfphasen-Abscheidung (CVD) aus Titanchlorid und Silan, in S. Veprek, P. Nesládek, A. Niederhofer, F. Glatz, M. Jílek, M. 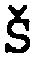 íma, Surface and Coatings Technology 108-109 (1998), S. 138 werden Titannitrid (Partikel) / Bornitrid (Matrix)-Schichten mittels einem kombinierten CVD-/PVD-Prozeß erzeugt (PVD - Physikalische Dampfphasenabscheidung). Dabei wird Titan-Dampf durch eine Niederdruck-Bogenentladung erzeugt. In einer Atmosphäre von Stickstoff und einer gasförmigen Bor-Verbindung (B₃N₃H₆) bilden sich dann TiN-Partikel und die BN-Matrix.

Aus der WO 97/00734 ist ein Verfahren zur Herstellung von keramischen Metallstrukturen bekannt, wobei Partikel in Form einer Schicht auf dem Substrat aufgetragen werden, im Anschluss die gebildete Partikelschicht mit einer aus einem Matrix-bildenden Material bestehenden Deckschicht überzogen wird und die Kompositschicht durch Energieeinwirkung auf das gebildete Schichtsystem hergestellt wird. Das Matrix-bildende Material wird dabei in einem Gewichtsverhältnis zwischen 5 und 25 Gew.-% eingesetzt.

Der Nachteil dieser Schichten ist, dass sie nur mit einem aufwendigen Verfahren und geringer Abscheidegeschwindigkeit hergestellt werden können.

Gemeinsamer Nachteil der bekannten Verfahren ist, dass stets Abscheidebedingungen gefunden werden müssen, die für beide Phasen (Partikel und Matrix) gleichermaßen geeignet sind. Beispielsweise ist es mit diesen Verfahren schwierig oder unmöglich, Kompositschichten herzustellen, die aus oxidischen Partikeln und einer metallischen Matrix bestehen. In der Regel wird man hierbei stets eine oxidische Matrix erhalten.

Ein weiterer entscheidender Nachteil besteht darin, dass mit diesen Verfahren nur sogenannte Nanokompositschichten hergestellt werden können. Das sind Kompositschichten, in denen die Partikelgröße äußerst gering ist und im Bereich von etwa 3 - 30 nm liegt.

Schließlich sind die mit den genannten Verfahren erreichbaren Schichtaufwachsraten sehr gering, was zu hohen Beschichtungskosten und somit eingeschränkter wirtschaftlicher Verwertung führt.

Aufgabe der vorliegenden Erfindung ist es daher, die hier genannten Nachteile des Standes der Technik zu beseitigen und dementsprechend eine verbesserte Kompositschicht sowie ein Verfahren zu deren Herstellung bereitzustellen.

Diese Aufgabe wird hinsichtlich des Verfahrens durch die Merkmale des Anspruches 1 und hinsichtlich der Kompositschicht durch die Merkmale des Anspruchs 18 gelöst. Die weiteren Unteransprüche zeigen vorteilhafte Weiterbildungen auf. In Anspruch 25 wird die Verwendung der nach dem erfindungsgemäßen Verfahren hergestellten Kompositschichten beschrieben.

Erfindungsgemäß wird ein Verfahren zur Herstellung einer Kompositschicht aus einer Partikel enthaltenden Matrix auf einem Substrat mit folgenden Schritten bereitgestellt:
a) Auftragung von Partikeln in Form einer Schicht auf dem Substrat;
b) Überziehen der gebildeten Partikelschicht mit einer aus der Matrix bestehenden Deckschicht, wobei der Matrixanteil 1 bis 50 Gew.-% beträgt;
c) Formierung der Kompositschicht durch Energieeinwirkung auf das gebildete Schichtsystem, wobei die Matrix in die Hohlräume der Partikelschicht eindringt.

Die Partikel, die für Schritt a) benötigt werden, können nach den aus dem Stand der Technik bekannten Herstellungsverfahren erhalten werden. Diese Partikel werden anschließend in Schritt a) auf das Substrat aufgebracht, wobei eine schichtartige Anordnung der Partikel mit möglichst geringen Zwischenräumen zwischen den Partikeln angestrebt wird.

In einer bevorzugten Variante ist es möglich, die Partikel direkt auf dem Substrat zu bilden und nachfolgend die so gebildete Partikelschicht mit einer Matrixschicht zu überziehen. Die Herstellung der Partikel erfolgt dabei bevorzugt mittels Hohlkathoden-Gasflußsputter-Anlagen.

In einer vorteilhaften Weiterbildung des Verfahrens kann vor Aufbringung der Partikelschicht auch das Substrat mit einer zusätzlichen Matrixschicht überzogen werden. Dies hat den Vorteil, dass dadurch eine bessere Haftung zwischen Substrat und Kompositschicht realisiert werden kann.

Die Aufbringung der Partikel erfolgt bevorzugt mittels eines Gasstromes, wofür sich besonders Gasfluß-Sputterquellen eignen. Ebenso ist es aber auch möglich, die Partikel auf das Substrat aufzuwirbeln, z.B. durch Anlegen einer geeigneten Vorspannung an das Substrat. Eine weitere Möglichkeit ist, die Partikel in einer Suspension auf das Substrat aufzutragen und anschließend die Flüssigkeit abzudampfen.

Als bevorzugte Partikel werden bevorzugt kristalline Hartstoff-Partikel eingesetzt. Unter diesen sind besonders Hartstoff-Partikel aus der Gruppe der metallischen Oxide, Carbide oder Nitride, wie z.B. Aluminiumoxid, Titanoxid, Siliciumdioxid, Siliciumcarbid, Titancarbid, Chromcarbid, Titannitrid, Aluminiumnitrid, Chromnitrid, Zirkonnitrid oder Bornitrid. Die Partikel haben dabei bevorzugt eine Korngröße im Bereich zwischen 5 nm und 5 µm. Dabei können auch unterschiedliche Partikelsorten eingesetzt werden. Ebenso ist es möglich, Partikel unterschiedlicher Korngröße einzusetzen, wodurch die Zwischenräume in der Partikelschicht zwischen den Partikeln stark reduziert werden können.

In einer weiteren vorteilhaften Ausführung des Verfahrens kann das Substrat mit einer elektrischen Vorspannung versehen werden, wodurch eine gezielte Steuerung der Anordnung der Partikel auf dem Substrat erfolgen kann.

In Schritt b) erfolgt anschließend die Auftragung einer aus der Matrix bestehenden Deckschicht auf die Partikelschicht. Bevorzugt werden für diese Auftragung der Matrixschicht vakuumtechnische Beschichtungsverfahren, wie z.B. PVD oder CVD, eingesetzt. Als Matrixmaterialien werden Metalle oder Legierungen mit Schmelzpunkten unterhalb von 1000 °C eingesetzt. Besonders bevorzugt werden hierbei Metalle, wie z.B. Zn, Sn, Al, Pb, Ga, In, Li oder Aufgrund eingesetzt.

Im Verfahrensschritt c) erfolgt anschließend die Formierung der Kompositschicht, bei der durch Energieeinwirkung auf das gebildete Schichtsystem die Matrix in die Hohlräume der Partikelschicht eindringen kann und die dort bestehenden Zwischenräume vollständig ausfüllt. Die Formierung erfolgt dabei bevorzugt durch thermische Energiezufuhr und/oder durch Ionenbeschuß im Plasma oder mittels einer Ionenquelle. Für die thermische Energiezufuhr werden dabei bevorzugt Temperaturen zwischen 100 und 1000 °C, besonders bevorzugt zwischen 300 und 800 °C gewählt. Bevorzugt liegt dabei die Temperatur etwas unterhalb der Erstarrungstemperatur der Matrix.

Die erfindungsgemäße Kompositschicht aus einer Partikel enthaltenden Matrix, die auf einem Substrat angeordnet ist, basiert auf einer Matrix aus einem Metall mit einem Schmelzpunkt unter 1000 °C, in die Partikel aus Metalloxid, Metallnitrid und/oder Metallcarbid eingebettet sind. Der Matrixanteil beträgt dabei zwischen 1 und 50 Gew.-%, wobei die Partikel einen Korngrößenbereich zwischen 5 nm und 5 µm aufweisen. Die Schichtdicke dieser Kompositschicht liegt in einem Bereich zwischen 20 nm und 200 pm, bevorzugt zwischen 100 nm und 10 µm.

In einer bevorzugten Ausführung weist die Kompositschicht lediglich einen Matrixanteil zwischen 1 und 15 Gew.-% auf.

Diese Kompositschichten, die aus kristallinen Hartstoff-Partikeln und einer amorphen, duktilen Matrix bestehen, aus einem Metall, sind von besonderem technischen Interesse. Nach dem Stand der Technik sind für die Bildung kristalliner Hartstoffe extreme thermische und chemische Bedingungen erforderlich, die gleichzeitig nicht mit den Matrix- und Substratmaterialien verträglich sind. Besonderer Vorteil des erfindungsgemäßen Verfahrens ist es nun, dass das Matrixmaterial derartigen aggressiven Bedingung nicht ausgesetzt ist. Dies ermöglicht die Herstellung neuer Kompositschichten die nach dem bisher bekannten Verfahren nicht möglich waren. Gleichzeitig kann durch den geringen Matrixanteil eine bedeutend höhere Festigkeit im Vergleich zu gleichartigen Kompositschichten mit geringerem Matrixanteil erzielt werden. Ein weiterer Vorteil des erfindungsgemäßen Verfahrens beruht darauf, dass nun auch Schichten aus Partikeln sehr unterschiedlicher Größe, insbesondere auch größerer Partikel ermöglicht werden. Dies führt dazu, dass im Vergleich zum Verfahren mit atomarer oder molekularer Schichtabscheidung eine beträchtlich höhere Abscheidegeschwindigkeit erreicht wird. Gleichzeitig ist dadurch eine gezielte Einstellung mechanischer, optischer und elektrischer Eigenschaften der Kompositschicht möglich.

Ein weiterer wesentlicher Vorteil beruht darauf, dass es sich um ein rein physikalisches Verfahren handelt und dass auf weitere Zusatzstoffe, wie z.B. Binder, vollständig verzichtet werden kann.

Verwendung finden diese Kompositschichten vor allem als Verschleißschutzschichten, Korrosionsschutzschichten, Wärmedämmschichten, optische und elektrische Funktionsschichten sowie Antihaft-Schichten.

Anhand der folgenden Figuren und Beispiele soll der erfindungsgemäße Gegenstand näher erläutert werden, ohne diesen auf diese Beispiele einzugrenzen.

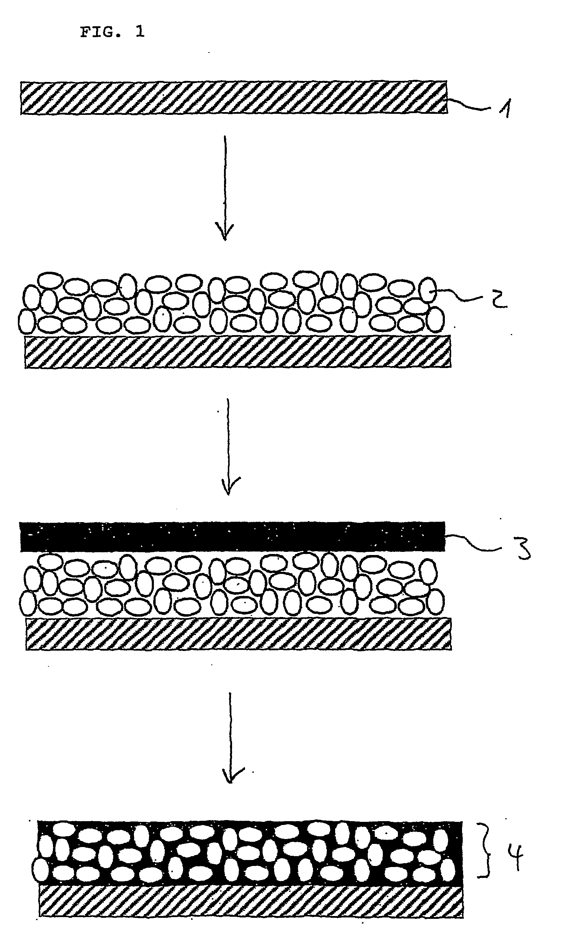

Fig. 1 zeigt eine schematische Darstellung des Herstellungsverfahrens. Das vorliegende Substrat (1) wird dabei zunächst mit den Hartstoff-Partikeln (2) beschichtet. Dies kann entweder durch Aufbringung der Partikel mit einem Gasstrom (z.B. aus einer Gasfluß-Sputterquelle), durch Aufwirbelung, elektrostatische Anziehung oder durch Aufbringung als Suspension und anschließender Verdampfung der Flüssigkeit erfolgen. Im anschließenden Verfahrensschritt wird die aus der Matrix bestehende Deckschicht (3) auf die Partikelschicht aufgetragen. Dies kann durch Aufstäuben mittels einer Hohlkathoden-Sputterquelle erfolgen. Ebenso ist es aber auch möglich, dass ein Aufdampfen dieser Schicht mittels Bogen- oder Schiffchenverdampfern durchgeführt wird. Anschließend erfolgt die Formierung der Kompositschicht (4) durch Energieeinwirkung auf das gebildete Schichtsystem, wobei die Matrixschicht (3) nun in die Hohlräume der Partikelschicht eindringt und diese ausfüllt.

### Beispiel 1

In einer beispielhaften Ausführung besteht die Kompositschicht aus einer Matrix aus Zink, in die kristalline Siliziumcarbid-Partikel mit einer mittleren Teilchengröße von 20 nm eingebettet sind. Die Schichtdicke beträgt 2 µm. Der Matrixanteil beträgt 45 Vol.-%.

### Beispiel 2

In einer weiteren beispielhaften Ausführung besteht die Kompositschicht aus einer Matrix aus Zinn, in die kristalline Titannitrid-Partikel mit einer mittleren Teilchengröße von 100 nm und kristalline Zirkonnitrid-Partikel mit einer mittleren Teilchengröße von 30 µm eingebettet sind. Die Schichtdicke beträgt 5 µm. Der Matrixanteil beträgt 25 Vol.-%.

### Beispiel 3

Zunächst erfolgt in einer beispielhaften Ausführung des Verfahrens eine nasschemische Reinigung des Substrates. Dieses gereinigte Substrat wird anschließend in eine Vakuumkammer eingebracht und die Vakuumkammer anschließend evakuiert. Das Substrat wird nun auf eine Temperatur von 150 °C aufgeheizt. Im Anschluss erfolgt dann die Auftragung der Partikelschicht aus Korund-Partikeln von 2 µm Dicke mittels einer Gasfluß-Sputterquelle. Nach Aufbringen der Partikelschicht wird diese durch eine Deckschicht überlagert. Diese Deckschicht besteht aus Kupfer und besitzt eine Dicke von 500 nm. Die Auftragung dieser Deckschicht erfolgt durch Aufdampfen mittels eines Bogenverdampfers. Das so hergestellte Schichtsystem wird anschließend auf 600 °C über eine Zeitdauer von 10 min aufgeheizt. Abschließend erfolgt dann eine Belüftung der Vakuumkammer und die Entnahme des mit einer Kompositschicht versehenen Substrates.

### Beispiel 4

Zunächst erfolgt eine nasschemische Reinigung des Substrates. Die Auftragung der Partikelschicht erfolgt hier durch Aufbringung einer Suspension aus Ethanol und Titannitrid-Partikeln mit einer mittleren Korngröße von 5 µm. Im Anschluss wird das Ethanol verdampft, wodurch eine Partikelschicht mit einer Dicke von 30 µm entsteht. Das auf diese Weise mit einer Partikelschicht versehene Substrat wird in eine Vakuumkammer eingebracht und diese evakuiert. Hier erfolgt die Aufbringung einer Deckschicht aus Zinn mit einer Schichtdicke von 10 µm durch Aufdampfen mittels eines Schiffchenverdampfers. Die Substrat-Temperatur wird anschließend auf 180 °C über eine Zeitdauer von 10 min erhöht. Abschließend erfolgt die Belüftung der Vakuumkammer und die Entnahme des beschichteten Substrates.

### Beispiel 5

Zunächst erfolgt eine Reinigung des Substrates auf nasschemischem Wege. Das so gereinigte Substrat wird in eine Vakuumkammer eingebracht und die Vakuumkammer evakuiert. Hier erfolgt eine Erwärmung des Substrates auf 150 °C. Das Substrat wird anschließend mit einer Grundschicht aus Zink als Matrixmaterial beschichtet. Dies erfolgt durch Aufstäuben mittels einer Hohlkathoden-Sputterquelle. Die resultierende Schichtdicke dieser Grundschicht beträgt 1 µm. Auf die Grundschicht wird im Anschluss eine Partikelschicht aus Zirkonoxid-Partikeln von 10 µm Dicke durch Aufwirbeln mittels eines Gasstrahls aufgetragen. Diese Partikelschicht wiederum wird mit einer Deckschicht aus Zink in einer Dicke von 3 µm überzogen. Dies erfolgt durch Aufstäuben mittels der gleichen Hohlkathoden-Sputterquelle. Anschließend wird das Substrat auf 350 °C über eine Zeitdauer von 15 min. erwärmt, was durch Einwirkung des Hohlkathodenplasmas bei einer Substratvorspannung von -80 V erfolgt. Abschließend erfolgt einer Belüftung der Vakuumkammer und die Entnahme des beschichteten Substrates.

## Patentansprüche

1. Verfahren zur Herstellung einer Kompositschicht aus einer Partikel enthaltenden Matrix auf einem Substrat mit folgenden Schritten:
a) Auftragung der Partikel in Form einer Schicht auf dem Substrat;
b) Überziehen der gebildeten Partikelschicht mit einer aus einem Matrix bildenden Material bestehenden Deckschicht;
c) Formierung der Kompositschicht durch Energieeinwirkung auf das gebildete Schichtsystem, wobei das Matrix bildende Material in die Hohlräume der Partikelschicht eindringt **dadurch gekennzeichnet, dass** der Matrixanteil in Verfahrensschritt b) 1 bis 50 Gew.-% beträgt.

2. Verfahren zur Herstellung nach Anspruch 1, **dadurch gekennzeichnet, dass** die Partikel direkt auf dem Substrat gebildet und nachfolgend das Verfahren mit dem Schritt b) und c) durchgeführt wird.

3. Verfahren nach Anspruch 1 oder 2, **dadurch gekennzeichnet, dass** vor Schritt a) auf dem Substrat zusätzlich eine Matrixschicht aufgetragen wird.

4. Verfahren nach Anspruch 1 bis 3, **dadurch gekennzeichnet, dass** die Partikel mittels Hohlkathoden-Gasflusssputtern erzeugt werden.

5. Verfahren nach mindestens einem der Ansprüche 1 bis 4, **dadurch gekennzeichnet, dass** die Partikel mittels eines Gasstroms, durch Aufwirbelung, elektrostatisch oder durch Aufbringung einer Suspension mit anschließender Verdampfung der Flüssigkeit auf dem Substrat abgeschieden werden.

6. Verfahren nach mindestens einem der Ansprüche 1 bis 5, **dadurch gekennzeichnet, dass** als Partikel kristalline Hartstoffpartikel verwendet werden.

7. Verfahren nach Anspruch 6, **dadurch gekennzeichnet, dass** Hartstoffpartikel ausgewählt aus der Gruppe der Metalloxide, -carbide, -nitride, insbesondere Aluminiumoxid, Titanoxid, Siliciumdioxid, Siliciumcarbid, Titancarbid, Chromcarbid, Titannitrid, Aluminiumnitrid, Chromnitrid, Zirkonnitrid oder Bornitrid eingesetzt werden.

8. Verfahren nach mindestens einem der Ansprüche 1 bis 7, **dadurch gekennzeichnet, dass** Partikel mit einer Korngröße im Bereich zwischen 5 nm und 5 µm eingesetzt werden.

9. Verfahren nach mindestens einem der Ansprüche 1 bis 8, **dadurch gekennzeichnet, dass** das Substrat mit einer elektrischen Vorspannung versehen wird.

10. Verfahren nach mindestens einem der Ansprüche 1 bis 9, **dadurch gekennzeichnet, dass** die Partikelschicht aus Partikeln unterschiedlichen Typus und/oder unterschiedlicher Korngröße gebildet wird.

11. Verfahren nach mindestens einem der Ansprüche 1
bis 10, **dadurch gekennzeichnet, dass** die Matrixschicht mittels vakuumtechnischer Beschichtungsverfahren, z.B. PVD oder CVD, aufgebracht wird.

12. Verfahren nach mindestens einem der Ansprüche 1 bis 11, **dadurch gekennzeichnet, dass** als Matrixmaterial Metalle oder Legierungen mit Schmelzpunkten unter 1000 °C eingesetzt werden.

13. Verfahren nach Anspruch 12, **dadurch gekennzeichnet, dass** die Metalle ausgewählt sind aus Zn, Sn, Al, Pb, Ga, In, Li und Ag.

14. Verfahren nach mindestens einem der Ansprüche 1 bis 11, **dadurch gekennzeichnet, dass** als Matrixmaterial ein Polymer eingesetzt wird.

15. Verfahren nach mindestens einem der Ansprüche 1 bis 11, **dadurch gekennzeichnet, dass** die Formierung der Kompositschicht im Verfahrensschritt c) durch thermische Energiezufuhr und/oder durch Ionen- oder Elektronenbeschuss im Plasma oder mittels einer Ionenquelle erfolgt.

16. Verfahren nach Anspruch 15, **dadurch gekennzeichnet, dass** die thermische Energiezufuhr bei Temperaturen zwischen 100 und 1000 °C, insbesondere zwischen 300 und 800 °C erfolgt.

17. Verfahren nach mindestens einem der Ansprüche 1 bis 16, **dadurch gekennzeichnet, dass** eine Schichtdicke der Kompositschicht von 20 nm bis 200 µm hergestellt wird.

18. Kompositschicht, die auf einem Substrat angeordnet ist aus einer Partikel enthaltenden Matrix, **dadurch gekennzeichnet,**
**dass** in eine Matrix aus unter 1000 °C schmelzendem Metall, Partikel aus Metalloxid, -nitrid, und/oder -carbid eingelagert sind und der Matrixanteil 1 bis 50 Gew-% beträgt, die Partikel eine Korngröße im Bereich von 5 nm bis 5 µm aufweisen und die Schichtdicke der Kompositschicht im Bereich von 20 nm bis 200 µm liegt.

19. Kompositschicht nach Anspruch 18, **dadurch gekennzeichnet, dass** das Matrixmaterial eine metallische Legierung ist.

20. Kompositschicht nach mindestens einem der Ansprüche 18 oder 19, **dadurch gekennzeichnet, dass** das Matrixmaterial ausgewählt ist aus Zn, Sn, Al, Pb, Ga, In, Li und Ag und/oder deren Legierungen.

21. Kompositschicht nach mindestens einem der Ansprüche 18 bis 20, **dadurch gekennzeichnet, dass** die Partikel ausgewählt sind aus Aluminiumoxid, Titanoxid, Siliciumdioxid, Siliciumcarbid, Titancarbid, Chromcarbid, Titannitrid, Aluminiumnitrid, Chromnitrid, Zirkonnitrid und Bornitrid.

22. Kompositschicht nach mindestens einem der Ansprüche 18 bis 21, **dadurch gekennzeichnet, dass** Partikel unterschiedlicher Korngröße und/oder unterschiedlichen Typus enthalten sind.

23. Kompositschicht nach mindestens einem der Ansprüche 18 bis 22, **dadurch gekennzeichnet, dass** der Matrixanteil 1 bis 15 Gew-% beträgt.

24. Kompositschicht nach mindestens einem der Ansprüche 18 bis 23, **dadurch gekennzeichnet, dass** die Dicke der Kompositschicht zwischen 100 nm und 10 µm liegt.

25. Verwendung eines Verfahrens nach mindestens einem der Ansprüche 1 bis 17 zur Herstellung einer Verschleißschutzschicht, Korrosionsschutzschicht, Wärmedämmschicht, optische und elektrische Funktionsschicht sowie Antihaftschicht.

## Claims

1. Method for production of a composite layer composed of a particle-containing matrix on a substrate having the following steps:
a) applying the particles in the form of a layer to the substrate;
b) coating the particle layer formed with a covering layer composed of a matrix-forming material;
c) forming the composite layer by applying energy to the layer system formed, the matrix-forming material penetrating the voids of the particle layer,
**characterised in that** the matrix proportion in method step b) is 1% to 50% by weight.

2. Method for production according to Claim 1, **characterised in that** the particles are formed directly on the substrate and subsequently the method is carried out with step b) and c).

3. Method according to Claim 1 or 2, **characterised in that**, before step a), a matrix layer is additionally applied to the substrate.

4. Method according to Claim 1 to 3, **characterised in that** the particles are produced by means of hollow-cathode gas flow sputtering.

5. Method according to at least one of Claims 1 to 4, **characterised in that** the particles are deposited on the substrate by means of a gas flow, by fluidising, electrostatically or by deposition of a suspension with subsequent evaporation of the liquid.

6. Method according to at least one of Claims 1 to 5, **characterised in that** crystalline hard-material particles are used as the particles.

7. Method according to Claim 6, **characterised in that** hard-material particles selected from the group of metal oxides, carbides, nitrides, in particular aluminium oxide, titanium oxide, silicon dioxide, silicon carbide, titanium carbide, chromium carbide, titanium nitride, aluminium nitride, chromium nitride, zirconium nitride or boron nitride are employed.

8. Method according to at least one of Claims 1 to 7, **characterised in that** particles with a particle size in the range between 5 nm and 5 µm are employed.

9. Method according to at least one of Claims 1 to 8, **characterised in that** the substrate is provided with an electrical bias voltage.

10. Method according to at least one of Claims 1 to 9, **characterised in that** the particle layer is formed from particles of different type and/or different particle size.

11. Method according to at least one of Claims 1 to 10, **characterised in that** the matrix layer is deposited by means of vacuum coating processes, e.g. PVD or CVD.

12. Method according to at least one of Claims 1 to 11, **characterised in that** metals or alloys with melting points below 1000°C are employed as the matrix material.

13. Method according to Claim 12, **characterised in that** the metals are selected from Zn, Sn, Al, Pb, Ga, In, Li and Ag.

14. Method according to at least one of Claims 1 to 11, **characterised in that** a polymer is employed as the matrix material.

15. Method according to at least one of Claims 1 to 11, **characterised in that** the forming of the composite layer in method step c) is carried out by thermal energy supply and/or by ion or electron bombardment in plasma or by means of an ion source.

16. Method according to Claim 15, **characterised in that** the thermal energy supply is carried out at temperatures between 100°C and 1000°C, in particular between 300°C and 800°C.

17. Method according to at least one of Claims 1 to 16, **characterised in that** a layer thickness of the composite layer of 20 nm to 200 µm is produced.

18. Composite layer which is arranged on a substrate and composed of a particle-containing matrix,
**characterised**
**in that** particles made of metal oxide, nitride, and/or carbide are embedded in a matrix made of metal which melts below 1000°C and the matrix proportion is 1% to 50% by weight, the particles having a particle size in the range from 5 nm to 5 µm and the layer thickness of the composite layer lying in the range from 20 nm to 200 µm.

19. Composite layer according to Claim 18, **characterised in that** the matrix material is a metallic alloy.

20. Composite layer according to at least one of Claims 18 or 19, **characterised in that** the matrix material is selected from Zn, Sn, Al, Pb, Ga, In, Li and Ag and/or alloys thereof.

21. Composite layer according to at least one of Claims 18 to 20, **characterised in that** the particles are selected from aluminium oxide, titanium oxide, silicon dioxide, silicon carbide, titanium carbide, chromium carbide, titanium nitride, aluminium nitride, chromium nitride, zirconium nitride and boron nitride.

22. Composite layer according to at least one of Claims 18 to 21, **characterised in that** particles of different particle size and/or different type are present.

23. Composite layer according to at least one of Claims 18 to 22, **characterised in that** the matrix proportion is 1 to 15% by weight.

24. Composite layer according to at least one of Claims 18 to 23, **characterised in that** the thickness of composite layer lies between 100 nm and 10 µm.

25. Use of a method according to at least one of Claims 1 to 17 for production of a wear protection layer, corrosion protection layer, heat-insulating layer, optical and electrical functional layer and anti-adhesion layer.

## Revendications

1. Procédé de fabrication d'une couche composite constituée d'une matrice contenant des particules sur un substrat, comprenant les étapes consistant à :
a) appliquer des particules sous la forme d'une couche sur le substrat ;
b) revêtir la couche de particules formée avec une couche de recouvrement constituée d'un matériau formant une matrice ;
c) former la couche composite sous l'action d'énergie appliquée sur le système de couches formé, le matériau formant une matrice pénétrant dans les espaces creux de la couche de particules,
**caractérisé en ce que** la fraction de matrice à l'étape de procédé b) est de 1 à 50 % en poids.

2. Procédé de fabrication selon la revendication 1, **caractérisé en ce que** les particules sont formées directement sur le substrat et **en ce que** le procédé est ensuite mis en oeuvre selon les étapes b) et c).

3. Procédé selon la revendication 1 ou 2, **caractérisé en ce que** l'on applique, avant l'étape a), une couche de matrice supplémentaire sur le substrat.

4. Procédé selon les revendications 1 à 3, **caractérisé en ce que** les particules sont produites au moyen d'une pulvérisation cathodique par flux gazeux à cathodes creuses.

5. Procédé selon au moins l'une quelconque des revendications 1 à 4, **caractérisé en ce que** les particules sont déposées au moyen d'un courant gazeux, par tourbillonnement, par voie électrostatique ou par application d'une suspension avec évaporation suivante du liquide, sur le substrat.

6. Procédé selon au moins l'une quelconque des revendications 1 à 5, **caractérisé en ce que** l'on utilise, comme particules, des particules de substance dure cristallines.

7. Procédé selon la revendication 6, **caractérisé en ce que** l'on utilise des particules de substance dure choisies dans le groupe constitué des oxydes, des carbures et des nitrures métalliques, en particulier, de l'oxyde d'aluminium, de l'oxyde de titane, du dioxyde de silicium, du carbure de silicium, du carbure de titane, du carbure de chrome, du nitrure de titane, du nitrure d'aluminium, du nitrure de chrome, du nitrure de zirconium ou du nitrure de bore.

8. Procédé selon au moins l'une quelconque des revendications 1 à 7, **caractérisé en ce que** l'on utilise des particules ayant une taille granulaire dans la plage comprise entre 5 nm et 5 µm.

9. Procédé selon au moins l'une quelconque des revendications 1 à 8, **caractérisé en ce que** le substrat est doté d'une tension de polarisation électrique.

10. Procédé selon au moins l'une quelconque des revendications 1 à 9, **caractérisé en ce que** la couche de particules est formée à partir de particules de type différent et/ou de taille granulaire différente.

11. Procédé selon au moins l'une quelconque des revendications 1 à 10, **caractérisé en ce que** la couche de matrice est appliquée au moyen d'un procédé de dépôt sous vide, par exemple, par PVD ou CVD.

12. Procédé selon au moins l'une quelconque des revendications 1 à 11, **caractérisé en ce que** l'on utilise, comme matériau de matrice, des métaux ou des alliages ayant des points de fusion inférieurs à 1000 °C.

13. Procédé selon la revendication 12, **caractérisé en ce que** les métaux sont choisis parmi les éléments Zn, Sn, Al, Pb, Ga, In, Li et Ag.

14. Procédé selon au moins l'une quelconque des revendications 1 à 11, **caractérisé en ce que** l'on utilise un polymère comme matériau de matrice.

15. Procédé selon au moins l'une quelconque des revendications 1 à 11, **caractérisé en ce que** la formation de la couche composite à l'étape de procédé c) est effectuée par un apport d'énergie thermique et/ou par un bombardement ionique ou électronique dans le plasma ou au moyen d'une source d'ions.

16. Procédé selon la revendication 15, **caractérisé en ce que** l'apport d'énergie thermique est effectué à des températures comprises entre 100 et 1000 °C, en particulier entre 300 et 800 °C.

17. Procédé selon au moins l'une quelconque des revendications 1 à 16, **caractérisé en ce que** l'on fabrique une épaisseur de couche composite de 20 nm à 200 µm.

18. Couche composite qui est disposée sur un substrat et qui est constituée d'une matrice contenant des particules, **caractérisée en ce que** :
on incorpore à une matrice constituée d'un métal fondant à une température inférieure à 1000 °C, des particules constituées d'oxyde, de nitrure et/ou de carbure métallique et **en ce que** la fraction de matrice est de 1 à 50 % en poids, les particules présentant une taille granulaire dans la plage de 5 nm à 5 µm et l'épaisseur de la couche composite se situant dans la plage de 20 nm à 200 µm.

19. Couche composite selon la revendication 18, **caractérisée en ce que** le matériau de matrice est un alliage métallique.

20. Couche composite selon au moins l'une quelconque des revendications 18 ou 19, **caractérisée en ce que** la matériau de matrice est choisi parmi les éléments Zn, Sn, Al, Pb, Ga, In, Li et Ag et/ou leurs alliages.

21. Couche composite selon au moins l'une quelconque des revendications 18 à 20, **caractérisée en ce que** les particules sont choisies parmi l'oxyde d'aluminium, l'oxyde de titane, le dioxyde de silicium, le carbure de silicium, le carbure de titane, le carbure de chrome, le nitrure de titane, le nitrure d'aluminium, le nitrure de chrome, le nitrure de zirconium et le nitrure de bore.

22. Couche composite selon au moins l'une quelconque des revendications 18 à 21, **caractérisée en ce qu'**elle contient des particules de taille granulaire différente et/ou de type différent.

23. Couche composite selon au moins l'une quelconque des revendications 18 à 22, **caractérisée en ce que** la fraction de matrice est de 1 à 15 % en poids.

24. Couche composite selon au moins l'une quelconque des revendications 18 à 23, **caractérisée en ce que** l'épaisseur de la couche composite se situe entre 100 nm et 10 µm.

25. Utilisation d'un procédé selon au moins l'une quelconque des revendications 1 à 17 pour fabriquer une couche de protection contre l'usure, une couche de protection contre la corrosion, une couche d'isolation thermique, une couche fonctionnelle optique et électrique, ainsi qu'une couche anti-adhésive.
